(19) Europäisches Patentamt
European Patent Office
Office européen des brevets

(11) Numéro de publication : **0 148 656 B1**

(12) # FASCICULE DE BREVET EUROPÉEN

(45) Date de publication du fascicule du brevet : **26.04.89**

(51) Int. Cl.⁴ : **H 01 S 3/16**, C 30 B 15/00, C 01 G 53/00

(21) Numéro de dépôt : **84402342.4**

(22) Date de dépôt : **16.11.84**

(54) **Nouveaux oxydes mixtes pour lasers accordables.**

(30) Priorité : **22.11.83 FR 8318575**

(43) Date de publication de la demande : **17.07.85 Bulletin 85/29**

(45) Mention de la délivrance du brevet : **26.04.89 Bulletin 89/17**

(84) Etats contractants désignés : **DE GB NL**

(56) Documents cités :
**DE-A- 1 544 279**
**FR-A- 1 360 038**
**FR-A- 1 494 447**
**CHEMICAL ABSTRACTS, vol. 81, no. 22, 2 décembre 1974, page 376, no. 142370s, Columbus, Ohio, US;P. PORTA et al.: "Distribution of nickel ions among octahedral and tetrahedral sites in nickel aluminum oxide-magnesium aluminium oxide(NiAl2O4-MgAl2O4)solid solutions" & J. SOLID STATE CHEM. 1974, 11(2),**

(73) Titulaire : **ETAT FRANCAIS représenté par le Ministre des PTT (Centre National d'Etudes des Télécommunications)**
**38-40 rue du Général Leclerc**
**F-92131 Issy-les-Moulineaux (FR)**

(72) Inventeur : **Auzel, François**
**C.N.E.T. 11, Place Levitt**
**F-78320 Le Mesnil Saint Denis (FR)**
Inventeur : **Moncorge, Richard**
**C.N.E.T. 54, Grande Rue**
**F-01600 Trevoux (FR)**
Inventeur : **Morin, Denise**
**C.N.E.T. 44, rue de Coulmiers**
**F-94130 Nogent sur Marne (FR)**

(74) Mandataire : **Mongrédien, André et al**
**c/o BREVATOME 25, rue de Ponthieu**
**F-75008 Paris (FR)**

EP 0 148 656 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet de nouveaux oxydes mixtes pour lasers accordables.

De façon plus précise, elle concerne des oxydes mixtes présentant un champ cristallin tel que l'émission accordable couvre la gamme de longueurs d'onde allant de 1 µm à 1,8 µm.

Il existe de nombreux oxydes mixtes et parmi ceux-ci, on connaît par la référence Chemical Abstracts, vol. 81, n° 22, décembre 1974, p. 376, n° 14 23 70 s, des oxydes de formule $Ni_xMg_{1-x}$ $Al_2O_4$ et par le brevet DE-A-1 544 279 des spinelles de formule (Mn, Fe) $(Al, Cr)_2O_4$, mais ces oxydes ne sont pas utilisés comme élément actif dans des lasers solides accordables.

Pour obtenir des lasers solides accordables, il est connu d'utiliser des ions de métaux de transition tels que $Cr^{3+}$, $V^{2+}$, $Ni^{2+}$ et $Co^{2+}$ comme ions dopants dans des oxydes tels que MgO et Be $Al_2$ $O_4$ et des fluorures tels que $MgF_2$, $ZnF_2$ et $KZnF_3$. Ainsi, l'article « Tunable alexandrite lasers » par Walling et Col. dans IEEE. J. Quantum Electron Vol. QE-16 n° 12 p. 1302-1314 (1980) illustre des lasers solides accordables dans la gamme de 0,7 à 0,82 µm obtenus en dopant $BeAl_2O_4$ par $Cr^{3+}$. L'article intitulé « Broadly tunable cw operation of Ni : $MgF_2$ and Co : $MgF_2$ lasers » de P.F. Moulton et Col. dans Appl. Phys. Lett. vol. 35 (11) p. 838-840 (1979) montre que l'on peut obtenir des lasers accordables dans les gammes 1,61 à 1,74 µm et 1,63 à 2,08 µm en dopant $MgF_2$ respectivement par Ni et par Co.

On connaît aussi des lasers accordables dans la gamme de 1,85 à 2,05 µm qui sont constitués par du $KZnF_3$ dopé par $Co^{2+}$ comme cela est décrit dans « CW IR laser action of optically pumped $Co^{2+}$ : $KZnF_3$ » par W. Kunzel et Col., Optics Communications, vol. 36, n° 5, p. 383-386 (1981).

Ainsi, aucun des matériaux mentionnés ci-dessus ne permet de couvrir la zone de longueur d'onde allant de 1,1 à 1,6 µm qui est intéressante, par exemple pour l'étude spectroscopique des alliages quaternaires semi-conducteurs du type In Ga As P. On connaît toutefois d'autres matériaux capables de convenir pour cette application ; ce sont $MgF_2$ : $V^{2+}$ et MgO : $Ni^{2+}$ qui couvrent respectivement la gamme 1,05-1,3 µm et 1,3-1,4 µm (voir Appl. Phys. Lett. 35, p. 838 (1979)).

Cependant, l'emploi de tels matériaux présente certains inconvénients. En effet, si l'on veut utiliser $MgF_2$ : $V^{2+}$, il est difficile de stabiliser le vanadium dans la valence 2, et tout ion résiduel dans un autre état de valence joue le rôle de poison qui réduit le rendement d'émission.

Par ailleurs, $V^{2+}$ dans $MgF_2$ possède un schéma de niveaux énergétiques tels que l'émission laser est réabsorbée à partir du niveau excité émettant l'effet laser. Aussi, les produits contenant du $V^{2+}$ dans des matrices fluorées sont difficiles à utiliser.

Dans le cas de MgO : $Ni^{2+}$, la principale difficulté réside dans la fabrication de ce produit sous la forme de monocristaux, car sa température de fusion est très élevée, environ 3 000 °C. Aussi, il est difficile d'obtenir des monocristaux de taille suffisante et de bonne qualité optique par les techniques de tirage classique, par exemple par la méthode de Czolchralski.

La présente invention a précisément pour objet des lasers solides accordables utilisant de nouveaux oxydes mixtes pour couvrir la zone de longueurs d'ondes allant de 1 à 1,8 µm, ces oxydes présentant par ailleurs l'avantage d'avoir des températures de fusion au plus égales à 2 000 °C.

Le laser accordable selon l'invention comprend un monocristal d'un oxyde mixte répondant à la formule :

$$(A_{1-x}X_x)_n\ (B_{1-y}Y_y)_m\ O_4$$

dans laquelle :

— A représente un élément choisi dans le groupe Mg, Mn et Zn ;
— X représente un cation bivalent optiquement actif choisi parmi V, Ni et Co ;
— B représente un élément choisi dans le groupe comprenant Si, Ge, P, Te, W, Al, In, Ga et Mo ;
— Y représente un cation trivalent optiquement actif choisi parmi Cr, V et Ni ;
— x est tel que $0 \leq x \leq 0{,}15$ ;
— y est tel que $0 \leq y \leq 0{,}15$ ; et
— m et n sont des nombres entiers tels que $2n + vm = 8$ avec v représentant la valence de B, à condition que $y = 0$ lorsque B représente un élément choisi parmi Si, Ge, P, Te, W et Mo, et que x et y ne soient pas tous deux égaux à 0.

Selon un premier mode de réalisation de l'invention, l'élément B représente un élément trivalent choisi parmi Al, In et Ga, qui peut être substitué en partie par un cation trivalent optiquement actif tel que Cr, V et Ni. Dans ce cas, l'oxyde mixte répond à la formule :

$$A_{1-x}X_x(B_{1-y}Y_y)_2O_4$$

A titre d'exemples de tels oxydes, on peut citer les oxydes de formule :

$$Mg_{1-x}\ Ni_x\ Al_2O_4 \text{ avec } 0 < x \leq 0{,}15$$

Selon un deuxième mode de réalisation de l'invention, l'élément B de la formule générale représente un élément tétravalent choisi parmi Si, Ge, W, Mo et Te et, dans ce cas seul l'élément A de la formule générale est remplacé en partie par un cation bivalent optiquement actif. Dans ce deuxième mode de réalisation de l'invention, l'oxyde mixte répond à la formule :

$$(A_{1-x}X_x)_2BO_4$$

A titre d'exemple de tels oxydes, on peut citer les oxydes de formule :

$$(Mg_{1-x}\ Ni_x)_2\ GeO_4 \text{ avec } 0 < x \leq 0{,}15$$

Selon un troisième mode de réalisation de l'invention, l'élément B est constitué par un élément hexavalent choisi parmi W et Mo. Dans ce cas, l'oxyde mixte répond à la formule.

$$A_{1-x}X_xBO_4$$

A titre d'exemples de tels oxydes, on peut citer les oxydes de formule :

$$Zn_{1-x}\ Ni_x\ WO_4 \text{ avec } 0 < x \leq 0{,}15$$

Selon une caractéristique de l'invention, les oxydes mixtes répondant aux formules précitées présentent un champ cristallin mesuré selon la méthode de Tanabe et Sugano tel que Dq/B soit au plus égal à 1,8. Des renseignements sur la méthode de Tanabe et Sugano peuvent être trouvés en particulier dans : « Solid State Physics », vol. 9 F. SEITZ and D. TURNBULL - Ac-Press p. 399 (1959).

Les oxydes mixtes de l'invention peuvent être préparés par des procédés classiques par exemple, en mélangeant intimement les quantités voulues de poudres d'oxydes ou de sels de A, de X, de B et de Y et en calcinant ensuite le mélange obtenu.

On peut aussi obtenir ces oxydes mixtes en coprécipitant des hydroxydes de A, de X, de B et de Y à partir d'une solution de leurs sels dans un solvant et en calcinant ensuite le coprécipité obtenu.

Lorsqu'on fabrique l'oxyde mixte à partir d'un mélange de poudres d'oxydes, on peut effectuer le mélange intime des poudres à l'état solide dans un mortier par broyage durant environ une demi heure, on peut aussi disperser les poudres dans un solvant organique tel que l'éther ou l'acétone, de façon à améliorer l'homogénéité du mélange, et agiter vivement la suspension pendant une demi heure environ. On élimine ensuite le solvant qui n'a aucun rôle chimique par évaporation.

Pour leur utilisation dans des lasers accordables les oxydes mixtes de l'invention sont ensuite transformés en monocristaux par des méthodes classiques, par exemple par fusion de zone, par tirage à partir d'un bain en fusion selon la méthode Czochralski, ou encore par la méthode de Verneuil.

D'autres caractéristiques et avantages de l'invention apparaitront mieux à la lecture des exemples suivants donnés bien entendu à titre illustratif et non limitatif en référence au dessin annexé sur lequel :

la figure 1 représente le diagramme théorique de Tanabe et Sugano pour $Ni^{2+}$, et

les figures 2, 3 et 4 représentent les spectres d'absorption et d'émission d'oxydes mixtes conformes à l'invention.

Exemple 1 : Préparation de $Mg_{0,99}\ Ni_{0,01}\ Al_2O_4$.

On part de poudres :

— de carbonate de magnésium $MgCO_3$, de qualité pour analyses commercialisé par Prolabo,

— de nitrate de nickel cristallisé $Ni(NO_3)_2$, $6H_2O$ de qualité pour analyses commercialisé par Prolabo, et

— d'alumine $Al_2O_3$ calcinée fabriquée par la société Merck.

On pèse des quantités de ces différentes poudres correspondant à la fabrication de l'oxyde mixte de formule : $Mg_{0,99}Ni_{0,01}Al_2O_4$, puis on les broie et on les mélange intimement dans un mortier d'alumine. On introduit ensuite le mélange dans un creuset de platine et on le chauffe dans un four à moufle à 800 °C pendant une heure pour la décomposition du nitrate, puis on rebroie le mélange de poudres, on le chauffe alors jusqu'à 1 500-1 600 °C et on le maintient pendant 17 heures à cette température dans un four à rhodium.

On forme à partir de l'oxyde mixte ainsi obtenu un monocristal par la Méthode de Verneuil.

On détermine les propriétés physiques (température de fusion, structure cristallographique, force du champ cristallin Dq/B et indice de réfraction) et les propriétés optiques (fluorescence - effet laser) du cristal ainsi obtenu. Les résultats sont donnés dans le tableau joint.

Au vu de ces résultats, on constate que la force du champ cristallin Dq/B est égale à 1,32 et qu'elle est légèrement supérieure à celle que l'on obtient avec MgO pour lequel Dq/B est égale à 0,85. Aussi, si l'on se réfère au diagramme théorique de Tanabe et Sugano représenté sur la figure 1 pour $Ni^{2+}$, on voit que l'écart énergétique des niveaux $^3T_2$ et $^3A_2$ est légèrement supérieur à celui obtenu avec MgO. On obtient

ainsi un effet laser sur les transitions vibroniques à une longueur d'onde légèrement inférieure par rapport à celle de MgO.

Sur la figure 2, on a représenté le spectre d'absorption (en trait plein) et le spectre d'émission (en tirets) de ce composé. On voit que le spectre d'absorption permet une excitation par des lasers commerciaux à krypton ayant une longueur d'onde λ de 640 à 670 nm et des lasers à grenat d'yttrium et d'aluminium de formule $Y_3Al_5O_{12}$ substitué par du néodyme, soit des lasers Y AG : Nd ayant une longueur d'onde de 1,06 μm. Le spectre d'émission représenté en tirets montre que l'émission correspond à une gamme d'accord, de 1,1 à 1,5 μm.

Exemple 2 : préparation de $Mg_{1,98}Ni_{0,02}GeO_4$.

On part de poudres :

— d'oxyde de germanium $GeO_2$ de qualité électronique fabriqué par la société Preussag,
— de carbonate de magnésium $MgCO_3$ de qualité pour analyses commercialisé par Prolabo, et
— de nitrate de nickel cristallisé $Ni(NO_3)_2$, $6H_2O$ de qualité pour analyses commercialisé par Prolabo.

On mélange les quantités voulues de ces différentes poudres pour obtenir $Mg_{1,98}Ni_{0,02}GeO_4$ et on les broie intimement dans un mortier d'alumine. On introduit ensuite le mélange dans un creuset de platine et on le chauffe dans un four à moufle à 800 °C pendant une heure pour décomposer le nitrate de nickel. On broie à nouveau le mélange, puis on le chauffe à 1 000 °C pendant une heure pour décomposer le carbonate. On rebroie alors et on chauffe le mélange dans un four à rhodium jusqu'à 1 300 °C, puis on le maintient à cette température pendant 17 heures environ, de sorte que la réaction à l'état solide est complète.

On transforme alors l'oxyde mixte ainsi obtenu en monocristal par la méthode de Czolchralski.

On mesure ensuite comme précédemment la température de fusion, la structure cristallographique, la force du champ cristallin Dq/B, l'indice de réfraction et les propriétés optiques (fluorescence et effet laser) de cet oxyde mixte. Les résultats obtenus sont donnés dans le tableau annexé. Au vu de ces résultats, on constate que le champ cristallin Dq/B est égal à 0,82 et qu'il est légèrement inférieur à celui de MgO (0,85).

Sur la figure 3, on a représenté le spectre d'absorption (en trait plein) et le spectre d'émission (en tirets) de ce composé. Ainsi, on voit que l'émission peut être obtenue dans la gamme de longueurs d'ondes allant de 1,35 à 1,8 μm et que l'excitation de ce matériau peut être effectuée par des lasers connus à krypton dans le domaine des longueurs d'ondes 0,64-0,67 μm et 0,75-0,79 μm, ou par un laser YAG : Nd à 1,06 ou 1,32 μm.

Exemple 3 : préparation de $Zn_{0,99}Ni_{0,01}WO_4$.

On part de poudres des composés suivants :

— anhydride tungstique chimiquement pur fabriqué par la société Riedel,
— oxyde de zinc de qualité pour analyses commercialisé par Prolabo, et
— nitrate de nickel cristallisé $Ni(NO_3)_2$, $6H_2O$ de qualité pour analyses de la société Prolabo.

On pèse les quantités voulues de poudres et on les mélange et on les broie intimement dans un mortier d'alumine. On introduit alors le mélange dans un creuset de platine et on le chauffe dans un four à moufle à 800 °C pendant une heure pour décomposer le nitrate de nickel, puis on le rebroie. On chauffe alors le mélange jusqu'à 1 300 °C et on le maintient à cette température dans un four à rhodium pendant 17 heures. On transforme alors le produit obtenu en monocristal par la méthode de Czolchralski.

On détermine alors comme précédemment la température de fusion, la structure cristallographique, l'indice de réfraction et les propriétés optiques (fluorescence et effet laser) de cet oxyde. Les résultats sont donnés dans le tableau annexé.

Au vu de ces résultats, on constate que le champ cristallin de ce composé Dq/B est de 0,7 et qu'il est relativement faible et à peu près équivalent à celui de $MgF_2$. De ce fait, la gamme d'accords est analogue à celle de $MgF_2$ : Ni, c'est-à-dire de 1,6 à 1,75 μm.

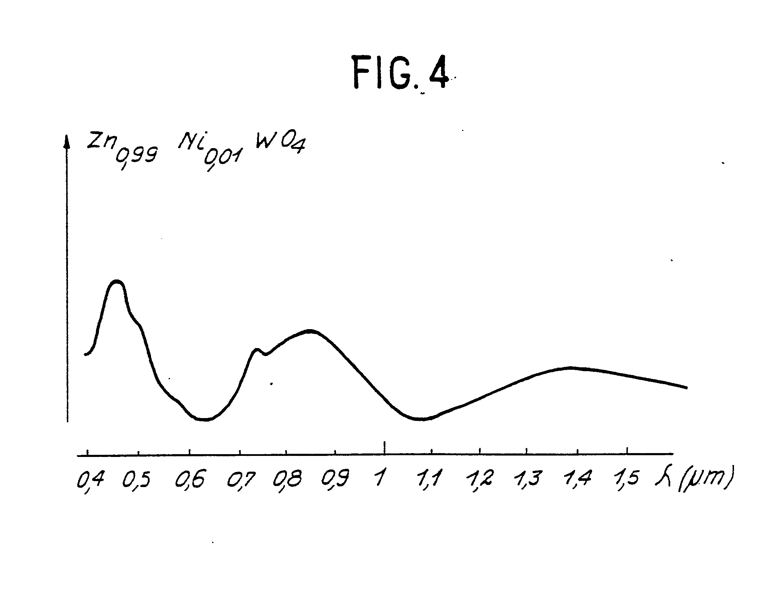

Sur la figure 4, on a représenté le spectre d'absorption de ce composé.

(Voir tableau page suivante)

Tableau

| | EXEMPLE 1 $Mg_{0,99}Ni_{0,01}Al_2O_4$ | EXEMPLE 2 $Mg_{1,98}Ni_{0,02}GeO_4$ | EXEMPLE 3 $Zn_{0,99}Ni_{0,01}WO_4$ |
|---|---|---|---|
| Température de fusion | 2000°C | 1850°C | 1360°C |
| Structure cristallographique | Spinelle (site octaédrique) | Orthorhombique | Monoclinique |
| Indice de réfraction | 1,72 | 1,71 | $\simeq$ 1,8 |
| Laser de pompe | Krypton 0,64-0,67 µm<br>YAG ($Nd^{3+}$) 1,06 µm | Krypton 0,64-0,67 µm<br>0,75-0,79 µm<br>YAG ($Nd^{3+}$) 1,06 µm; 1,32 µm | Krypton 0,75-0,79 µm<br>YAG ($Nd^{3+}$) 1,32 µm |
| Force du champ cristallin Dq/B | 1,32 | 0,82 | 0,67 |
| Domaine d'émission infrarouge $^3T_2 \rightarrow {}^3A_2$ | 1,1-1,5 µm | 1,35-1,8 µm | $\simeq$ 1,6-1,75 µm |
| Durée de vie de fluorescence $\tau f$ | 1,35 ms | 420 µs | - |
| Rendement quantique $\eta = \tau f/\tau_o$ | $\simeq$ 1 | $\simeq$ 1 | - |
| Largeur de bande à mi-hauteur $\delta\nu$ | 1260 $cm^{-1}$ | 1100 $cm^{-1}$ | $\simeq$ 1050 $cm^{-1}$ |
| Section efficace laser $\sigma_\ell$ | 7,1 x $10^{-21}$ $cm^2$ | 2,4 x $10^{-20}$ $cm^2$ | - |

## Revendications

1. Laser accordable comprenant un monocristal d'un oxyde mixte répondant à la formule :

$$(A_{1-x}X_x)_n\ (B_{1-y}Y_y)_m\ O_4$$

dans laquelle :
— A représente un élément choisi dans le groupe Mg, Mn et Zn ;
— X représente un cation bivalent optiquement actif choisi parmi V, Ni et Co ;
— B représente un élément de même valence choisi dans le groupe comprenant Si, Ge, P, Te, W, Al, In, Ga et Mo ;
— Y représente un cation trivalent optiquement actif choisi parmi Cr, V et Ni ;
— x est tel que $0 \leq x \leq 0{,}15$ ;
— y est tel que $0 \leq y \leq 0{,}15$ ; et
— m et n sont des nombres entiers tels que $2n + vm = 8$ avec v représentant la valence de B, à condition que y = 0 lorsque B représente un élément choisi parmi Si, Ge, P, Te, W et Mo, et que x et y ne soient pas tous deux égaux à 0.

2. Laser accordable selon la revendication 1, caractérisé en ce que l'oxyde mixte répond à la formule :

$$(A_{1-x}X_x)\ (B_{1-y}Y_y)_2O_4$$

dans laquelle : B représente un élément trivalent choisi parmi Al, In et Ga.

3. Laser accordable selon la revendication 1, caractérisé en ce que l'oxyde mixte répond à la formule :

$$(A_{1-x}X_x)_2BO_4$$

dans laquelle B représente un élément tétravalent choisi parmi Si, Ge, W, Mo et Te.

4. Laser accordable selon la revendication 1, caractérisé en ce que l'oxyde mixte répond à la formule :

$$A_{1-x}X_xBO_4$$

dans laquelle B représente un élément hexavalent choisi parmi W et Mo.

5. Laser accordable selon la revendication 1, caractérisé en ce que l'oxyde mixte répond à la formule :

$$Mg_{1-x}Ni_xAl_2O_4$$

dans laquelle x est un nombre tel que $0 < x \leq 0{,}15$.

6. Laser accordable selon la revendication 1, caractérisé en ce que l'oxyde mixte répond à la formule :

$$(Mg_{1-x}\ Ni_x)_2\ GeO_4$$

dans laquelle x est un nombre tel que $0 < x \leq 0{,}15$.

7. Laser accordable selon la revendication 1, caractérisé en ce que l'oxyde mixte répond à la formule :

$$Zn_{1-x}\ Ni_x\ WO_4$$

dans laquelle x est un nombre tel que $0 < x \leq 0{,}15$.

8. Laser accordable selon l'une quelconque des revendications 1 à 7, caractérisé en ce que l'oxyde mixte présente un champ cristallin mesuré selon la méthode de Tanabe et Sugano tel que $Dq/B \leq 1{,}8$.

## Claims

1. Tunable laser, comprising a monocrystal of a mixed oxide in accordance with the formula :

$$(A_{1-x}X_x)_n(B_{1-y}Y_y)_mO_4$$

in which :
— A represents an element chosen from the group Mg, Mn and Zn ;

— X represents an optically active divalent cation chosen from among V, Ni and Co ;
— B represents an element of the same valence chosen in the group comprising Si, Ge, P, Te, W, Al, In, Ga and Mo ;
— Y represents an optically active trivalent cation chosen from among Cr, V and Ni ;
— x is such that $0 \leqslant x \leqslant 0.15$ ;
— y is such that $0 \leqslant y \leqslant 0.15$ ; and
— m and n are integers such that $2n + vm = 8$ with v representing the valence of B, provided that $y = 0$ when B represents an element chosen from among Si, Ge, P, Te, W and Mo and x and y are not both equal to 0.

2. Tunable laser according to claim 1, characterized in that the mixed oxide is in accordance with the formula :

$$(A_{1-x}X_x)\,(B_{1-y}Y_y)_2O_4$$

in which B represents a trivalent element chosen from among Al, In and Ga.

3. Tunable laser according to claim 1, characterized in that the mixed oxide is in accordance with the formula :

$$(A_{1-x}X_x)_2BO_4$$

in which B is a trivalent element chosen from among Si, Ge, W, Mo and Te.

4. Tunable laser according to claim 1, characterized in that the mixed oxide is in accordance with formula :

$$A_{1-x}X_xBO_4$$

in which B represents a hexavalent element chosen from among W and Mo.

5. Tunable laser according to claim 1, characterized in that the mixed oxide is in accordance with formula

$$Mg_{1-x}Ni_xAl_2O_4$$

in which x is a number such that $0 < x \leqslant 0.15$.

6. Tunable laser according to claim 1, characterized in that the mixed oxide is in accordance with the formula

$$(Mg_{1-x}Ni_x)_2GeO_4$$

in which x is a number such that $0 < x \leqslant 0.15$.

7. Tunable laser according to claim 1, characterized in that the mixed oxide is in accordance with the formula :

$$Zn_{1-x}Ni_xWO_4$$

in which x is a number such that $0 < x \leqslant 0.15$.

8. Tunable laser according to any one of the claims 1 to 7, characterized in that the mixed oxide has a crystal field measured according to the Tanabe and Sugano method such that $Dq/B \leqslant 1.8$.

## Patentansprüche

1. Abstimmbarer Laser, der umfaßt einen Einkristall aus einem Mischoxid der Formel

$$(A_{1-x}X_x)_n\,(B_{1-y}Y_y)_m\,O_4$$

worin bedeuten :
— A ein Element, ausgewählt aus der Gruppe Mg, Mn und Zn ;
— X ein optisch aktives bivalentes Kation, ausgewählt aus V, Ni und Co ;
— B ein Element mit der gleichen Valenz, ausgewählt aus der Gruppe, die umfaßt Si, Ge, P, Te, W, Al, In, Ga und Mo ;
— Y ein optisch aktives trivalentes Kation, ausgewählt aus Cr, V und Ni ;
— x eine Zahl, die der Bedingung genügt $0 \leqslant x \leqslant 0{,}15$ ;
— y eine Zahl, die der Bedingung genügt $0 \leqslant y \leqslant 0{,}15$ ; und
— m und n ganze Zahlen, die der Bedingung genügen $2n + vm = 8$, worin v die Valenz von B

darstellt, mit der Maßgabe, daß y = 0, wenn B ein Element, ausgewählt aus Si, Ge, P, Te, W und Mo darstellt, und daß x und y nicht alle beide 0 bedeuten.

2. Abstimmbarer Laser nach Anspruch 1, dadurch gekennzeichnet, daß das Mischoxid der Formel entspricht

$$(A_{1-x}X_x)\ (B_{1-y}Y_y)_2O_4$$

worin B ein trivalentes Element, ausgewählt aus Al, In und Ga darstellt.

3. Abstimmbarer Laser nach Anspruch 1, dadurch gekennzeichnet, daß das Mischoxid der Formel entspricht :

$$(A_{1-x}X_x)_2BO_4$$

worin B ein tetravalentes Element, ausgewählt aus Si, Ge, W, Mo und Te, darstellt.

4. Abstimmbarer Laser nach Anspruch 1, dadurch gekennzeichnet, daß das Mischoxid der Formel entspricht :

$$A_{1-x}X_xBO_4$$

worin B ein hexavalentes Element, ausgewählt aus W und Mo, darstellt.

5. Abstimmbarer Laser nach Anspruch 1, dadurch gekennzeichnet, daß das Mischoxid der Formel entspricht :

$$Mg_{1-x}Ni_xAl_2O_4$$

worin x eine ganze Zahl bedeutet, die der Bedingung genügt $0 < x \leqslant 0,15$.

6. Abstimmbarer Laser nach Anspruch 1, dadurch gekennzeichnet, daß das Mischoxid der Formel entspricht :

$$(Mg_{1-x}Ni_x)_2GeO_4$$

worin x eine Zahl darstellt, die der Bedingung genügt $0 < x \leqslant 0,15$.

7. Abstimmbarer Laser nach Anspruch 1, dadurch gekennzeichnet, daß das Mischoxid der Formel entspricht :

$$Zn_{1-x}Ni_xWO_4$$

worin x eine Zahl darstellt, die der Bedingung $0 < x \leqslant 0,15$ genügt.

8. Abstimmbarer Laser nach einem der Ansprüche 1 bis 7, dadurch gekennzeichnet, daß das Mischoxid ein kristallines Feld, gemessen nach der Methode von Tanabe und Sugano, darstellt, das der Bedingung genügt $Dq/B \leqslant 1,8$.

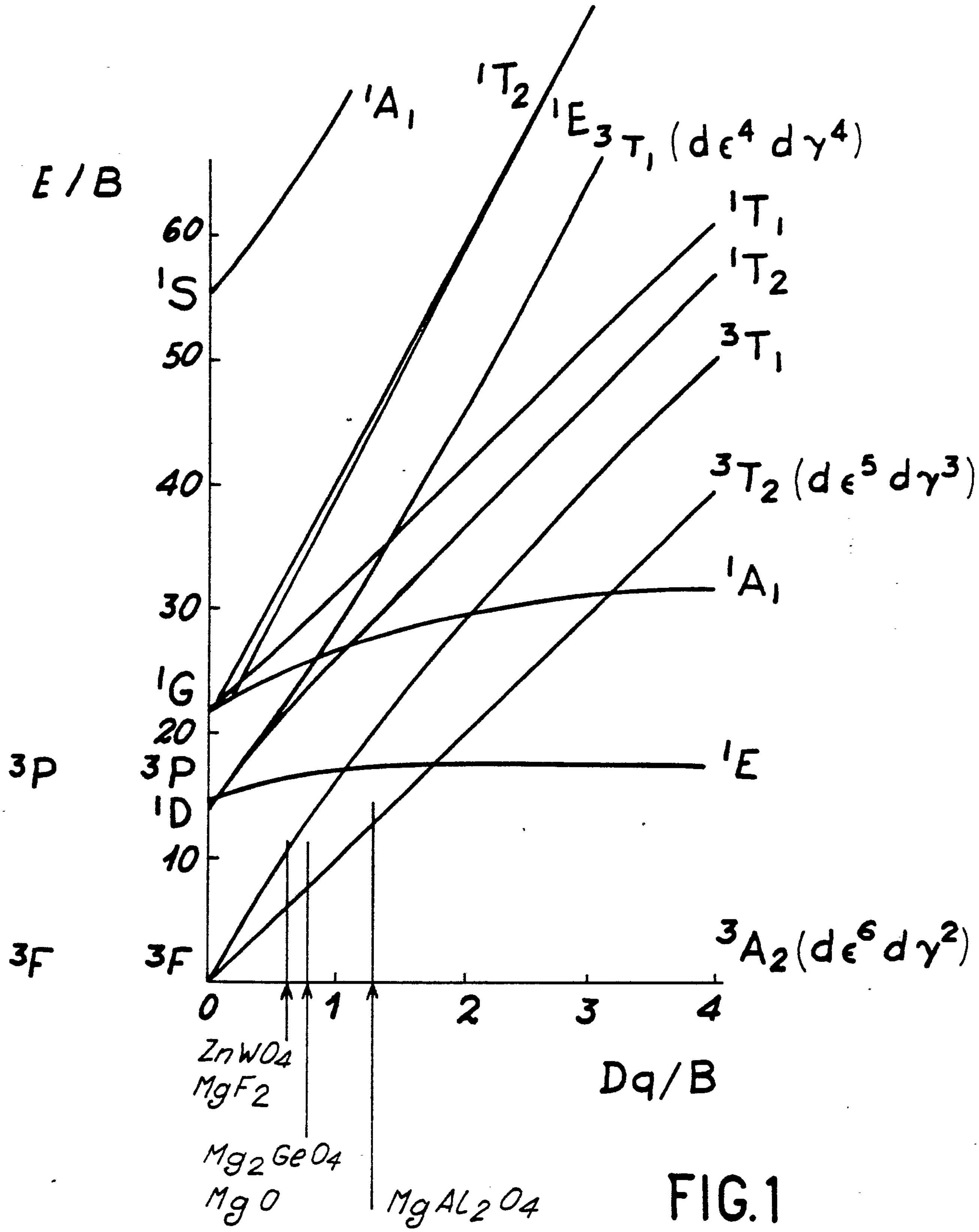
E / B
60
50
40
30
20
10
$^1S$
$^1G$
$^3P$
$^3P$
$^1D$
$^3F$
$^3F$
$^1A_1$
$^1T_2$
$^1E$
$^3T_1$ $(d\epsilon^4 d\gamma^4)$
$^1T_1$
$^1T_2$
$^3T_1$
$^3T_2$ $(d\epsilon^5 d\gamma^3)$
$^1A_1$
$^1E$
$^3A_2$ $(d\epsilon^6 d\gamma^2)$
0
1
2
3
4
Dq/B
$ZnWO_4$
$MgF_2$
$Mg_2GeO_4$
MgO
$MgAL_2O_4$

FIG.1

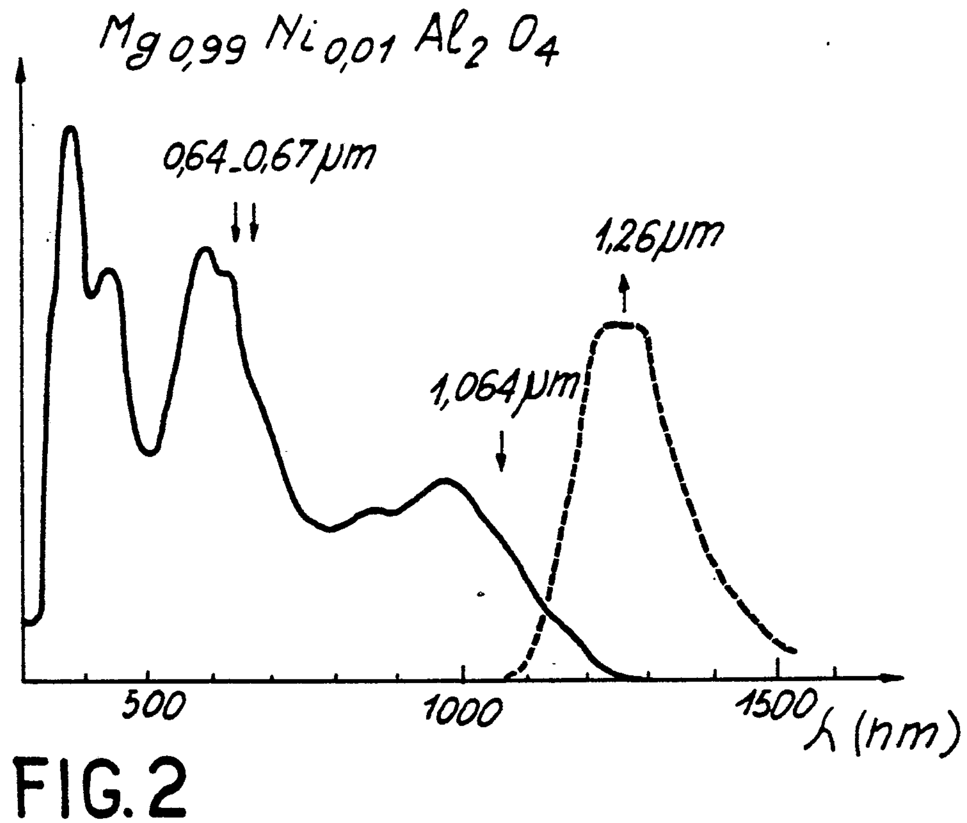
Mg 0,99 Ni 0,01 Al2 O4
0,64-0,67 µm
1,26 µm
1,064 µm
500
1000
1500
λ (nm)

FIG. 2

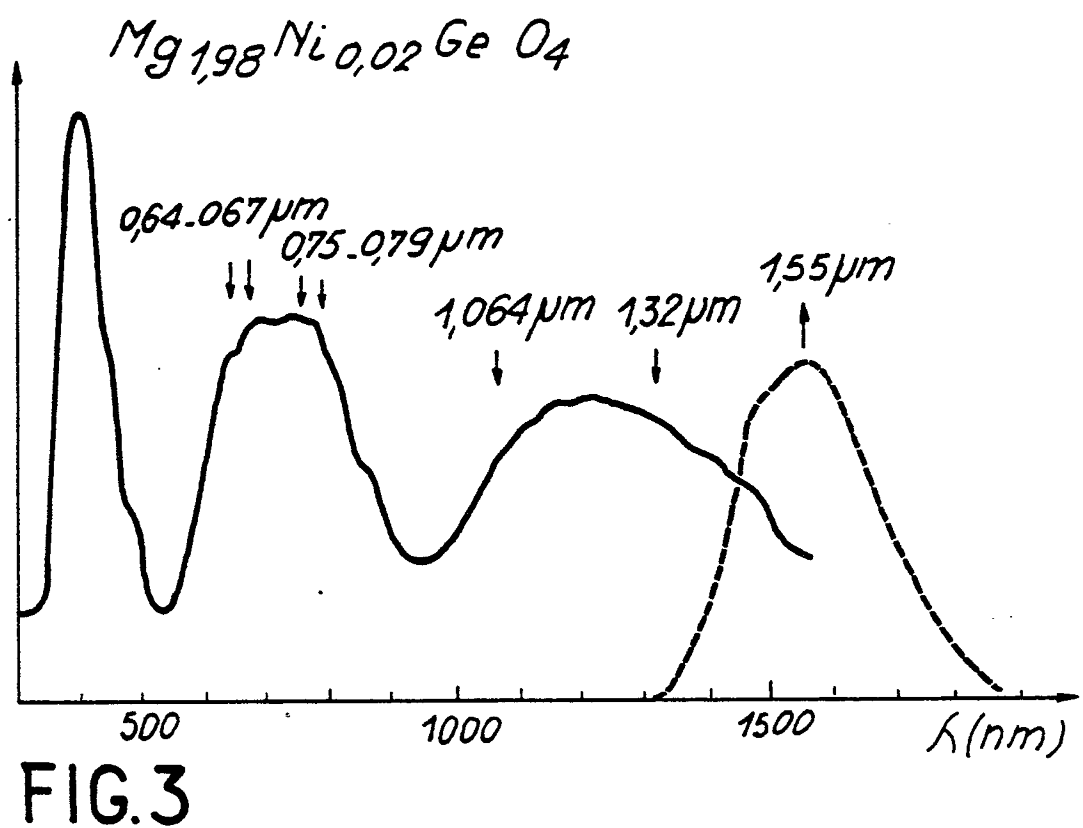
Mg 1,98 Ni 0,02 Ge O4
0,64-067 µm
0,75-0,79 µm
1,064 µm
1,32 µm
1,55 µm
500
1000
1500
λ (nm)

FIG. 3

FIG. 4